# FASCICULE DE BREVET EUROPEEN

(11) **EP 1 677 146 B1**
(45) Date de publication et mention de la délivrance du brevet: **19.09.2012**
(21) Numéro de dépôt: 05112633.2
(22) Date de dépôt: 21.12.2005
(51) Int. Cl.: G03F 1/20, H01J 37/32

(54) **Dispositif de fabrication d'un masque par gravure par plasma d'un substrat semiconducteur**
Vorrichtung zur Herstellung einer Maske für die Plasmaätzung eines Halbleitersubstrats
Device for manufacturing a mask by plasma etching of a semiconductor substrate

(30) Priorité: 03.01.2005 FR 0550002
(43) Date de publication de la demande: 05.07.2006
(73) Titulaire: Alcatel Lucent, 75007 Paris (FR)
(72) Inventeur: Puech, Michel, 74370, METZ-TESSY (FR); Chabloz, Martial, 279-0042, URAYASU-SHI (JP)
(74) Mandataire: Sciaux, Edmond

(56) Documents cités:
- EP-A- 0 786 804
- US-B1- 6 531 249
- IL-YONG JANG ET AL: "Development of etch rate uniformity adjustment technology for photomask quartz etch in manufacturing the 100% attenuated PSM" PROCEEDINGS OF THE SPIE - THE INTERNATIONAL SOCIETY FOR OPTICAL ENGINEERING SPIE-INT. SOC. OPT. ENG USA, vol. 5130, no. 1, 26 août 2003 (2003-08-26), pages 246-252, XP002345112 ISSN: 0277-786X
- JOHNSTON I R ET AL: "Etching 200-mm diameter SCALPEL(R) masks with the ASE(R) process" PROCEEDINGS OF THE SPIE - THE INTERNATIONAL SOCIETY FOR OPTICAL ENGINEERING SPIE-INT. SOC. OPT. ENG USA, vol. 3997, 2000, pages 184-193, XP002345113 ISSN: 0277-786X
- DAUKSHER W J ET AL: "Modeling and development of a deep silicon etch process for 200 mm election projection lithography mask fabrication" JOURNAL OF VACUUM SCIENCE & TECHNOLOGY B (MICROELECTRONICS AND NANOMETER STRUCTURES) AIP FOR AMERICAN VACUUM SOC USA, vol. 19, no. 6, novembre 2001 (2001-11), pages 2921-2925, XP002345114 ISSN: 0734-211X
- DAUKSHER W J ET AL: "Modeling and experimental data using a new high rate ICP tool for dry etching 200 mm EPL masks" MICROELECTRONIC ENGINEERING ELSEVIER NETHERLANDS, vol. 61-62, juillet 2002 (2002-07), pages 887-894, XP002345115 ISSN: 0167-9317

## Description

La présente invention concerne le domaine de la microlithographie par projection d'un faisceau d'électrons dite "EPL" (pour "Electron Projection Lithography" en anglais), notamment employée pour la réalisation de masques destinés à être utilisés dans la fabrications de composants micro-électroniques aux dimensions sub-microniques. L'invention est destinée à être utilisée notamment dans la gravure de motifs de 65 nm à 45 nm dans des matériaux semi-conducteurs. L'invention se rapporte plus particulièrement à un dispositif utilisé pour la fabrication d'un masque par gravure par plasma d'un substrat semiconducteur, et notamment au contrôle de l'uniformité de la profondeur de gravure et de l'uniformité des angles des motifs sur toute la surface du substrat.

Le micro-usinage des substrats en silicium est actuellement réalisé par des techniques de gravure au plasma, telle que celle décrite dans le document US 5 501 893. Cette technique consiste à protéger partiellement le substrat de silicium par un masque de gravure, et à soumettre le substrat ainsi protégé partiellement à une succession alternée d'étapes d'attaque par plasma de gaz de gravure et d'étapes de passivation par plasma de gaz de passivation. Pour fabriquer le masque de gravure, un motif à graver est transféré sur le substrat à partir d'un masque de transmission. Le transfert est habituellement réalisé par la technique de photolithogravure consistant à insoler le substrat à travers le masque de transmission par un rayonnement photonique. Les masques de transmission sont eux-mêmes fabriqués à partir d'un masque-modèle le plus souvent réalisé à l'aide d'un pinceau électronique très fin, de dimension inférieure à la plus petite des dimensions du motif à obtenir, piloté par des moyens informatiques, qui balaye la surface d'un substrat en résine électrosensible pour y dessiner le motif souhaité. Une telle opération est très longue. Les masques de transmission sont donc réalisés par une technique différente, notamment pour des raisons de coût.

Au cours des dernières années, les exigences en matière de miniaturisation et de complexité des composants semiconducteurs se sont accrues. La photolithographie telle qu'elle est actuellement utilisée a atteint sa limite en matière de résolution des tracés. On se tourne aujourd'hui vers des techniques lithographiques utilisant des longueurs d'onde plus courtes telle que des faisceaux d'électrons ou d'ions et le rayonnement X.

Les masques employés pour insoler les substrats semiconducteurs par un faisceau d'électrons présentent généralement la forme d'un réseau dans lequel des petites surfaces portant le motif à graver sont séparées par un réseau de banquettes de plus grande épaisseur. Ces petites surfaces sont supportées par une membrane d'épaisseur faible, de l'ordre de 2µm. Des exemples de tels masques sont par exemple décrits dans le document US-6,352,802. Un faisceau d'électrons ayant une section du même ordre de grandeur que la petite surface est envoyé sur le masque et projette une image réduite des motifs à graver à travers ces surfaces sur le substrat destiné à devenir un composant microélectronique. Pour obtenir une image projetée convenable du masque, il est essentiel que la membrane constituant chacune de ces petites surfaces ait une épaisseur constante.

Or on a constaté que, lors de la gravure par plasma de ces masques, on obtenait une épaisseur de la membrane plus importante sur les bords du masque de transmission qu'au centre. Un tel défaut entraîne ensuite une inhomogénéité de l'insolation du substrat semiconducteur à travers le masque qui conduit à une gravure inégale du substrat et donc le rebut de ces produits.

Le document EP 0 786 804 décrit un dispositif de gravure par plasma comportant des éléments de confinement du plasma en périphérie du substrat.

La présente invention a pour but de proposer un dispositif et un procédé permettant d'obtenir une épaisseur de membrane constante sur toute la surface du masque de transmission, lors de la fabrication de ces masques en vue de leur utilisation pour la microlithographie par faisceau d'électrons.

L'objet de la présente invention est un dispositif de fabrication d'un masque par gravure par plasma d'un substrat semiconducteur qui comprend un substrat semiconducteur dont une partie de la surface est partiellement recouverte d'un masque protégeant au moins une zone qui ne doit pas être gravée et laissant apparente au moins une zone comportant un motif à graver, un support pour le substrat, un moyen de génération d'un plasma sous forme d'un flux d'ions en direction du substrat et un moyen de confinement desdits ions. Selon l'invention le moyen de confinement des ions comporte au moins un écran en matériau conducteur disposé au-dessus du substrat et le long de la limite séparant la zone de motif à graver de la zone ne devant pas être gravée, ledit écran ayant la forme de plaques verticales disposées parallèlement à chacun des côtés de la zone de motif à graver en forme de quadrilatère.

Pour une meilleure efficacité, l'écran est disposé à une distance constante de la limite de ladite zone de motif à graver. L'écran est disposé à une distance constante horizontale à l'extérieure de ladite limite, de manière à ne pas masquer

une partie du motif. L'écran est donc placé au-dessus du substrat à la verticale de la zone ne devant pas être gravée. L'écran est de préférence disposé à une distance constante verticale du substrat laissant un intervalle ouvert entre l'écran et le substrat. De préférence la distance constante est inférieure à 10mm. L'écran a une hauteur qui est de préférence comprise entre 5mm et 20mm.

Avantageusement le substrat comporte une pluralité de zones comportant des motifs à graver séparées les unes des autres par des zones ne devant pas être gravée. Ainsi on peut réaliser plus rapidement et à moindre coût un nombre élevé de motifs. Lorsque le substrat comporte plusieurs motifs à graver, chaque zone à graver est entourée de son propre écran.

De préférence, l'écran s'interrompt aux angles du quadrilatère lorsque cet angle est distant d'une autre zone de motif à graver d'une distance inférieure ou égale à la distance constante séparant l'écran de la limite de la zone de motif à graver afin d'éviter les effets de bord.

Selon un mode particulier de réalisation de l'invention, l'écran s'interrompt aux angles du quadrilatère lorsque l'angle est distant d'une pièce en matériau conducteur d'une distance inférieure ou égale à la distance constante séparant l'écran de la limite de la zone de motif à graver afin d'éviter les effets de bord.

La présente invention a comme avantage de confiner le rayonnement plasma dans une surface correspondant uniquement à la surface du masque portant les motifs que l'on souhaite graver, de manière à assurer une vitesse de gravure verticale, par exemple 3*µ*m/mn ± 6%, qui soit uniforme sur toute la surface du substrat.

D'autres objets, caractéristiques et avantages de la présente invention ressortiront de la description suivante de modes de réalisation particuliers, donnés bien entendu à titre illustratif et non limitatif, et dans le dessin annexé sur lequel :
- la figure 1 est une représentation schématique de l'insolation d'un substrat semi-conducteur par un faisceau d'électrons à travers un masque de transmission,
- la figure 2 montre en perspective un masque de transmission recevant un faisceau d'électrons,
- la figure 3 est une représentation schématique du dispositif selon la présente invention,
- la figure 4 montre en perspective le dispositif selon la présente invention,
- la figure 5 est une coupe schématique selon A-A de la figure 3, l'invention étant définie par les revendications.

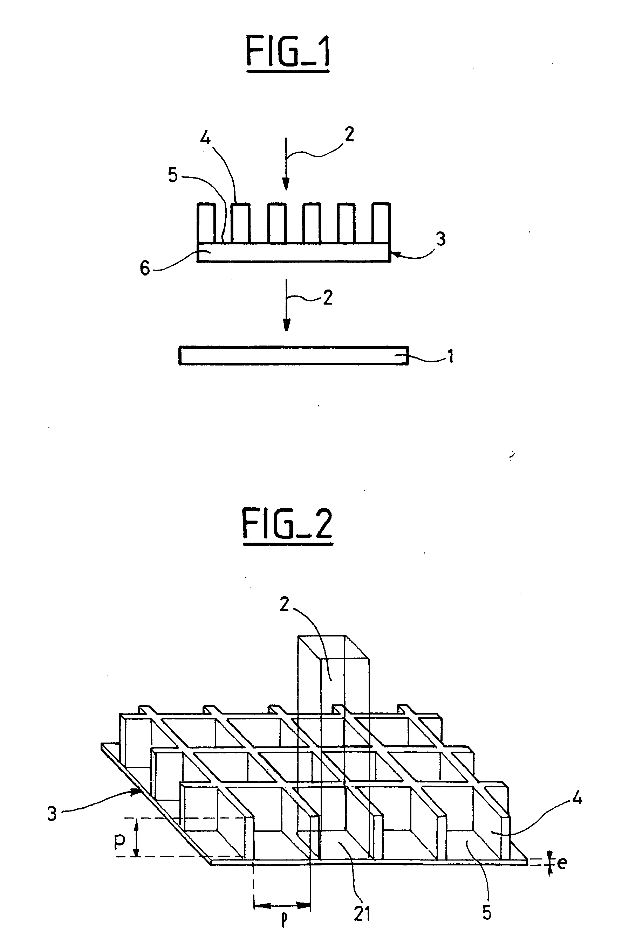

Sur le schéma de la figure 1, on voit une plaquette 1 d'un substrat semi-conducteur qui est insolée par un faisceau d'électron 2 traversant un masque de transmission 3. Le masque 3 comporte des reliefs 4 séparant des petites surfaces 5 de membrane 6 de faible épaisseur portant le motif à graver. Les dimensions du motif porté par le masque sont divisées environ par 4 lors de sa reproduction sur le substrat.

Le masque 3 est montré en perspective sur la figure 2. Il comporte des reliefs 4 d'une profondeur p de 725*µ*m par exemple. La petite surface 5 portant le motif à graver est par exemple une surface carrée de 1,13mm de côté. La surface 5 peut en outre comporter des trous de 120nm de diamètre par exemple. La membrane 6 a une épaisseur e de 2*µ*m par exemple. Un faisceau d'électron 2 est envoyé sur le masque 3. Le faisceau 2 traverse la surface 5 pour recopier le motif qu'elle porte sur le substrat.

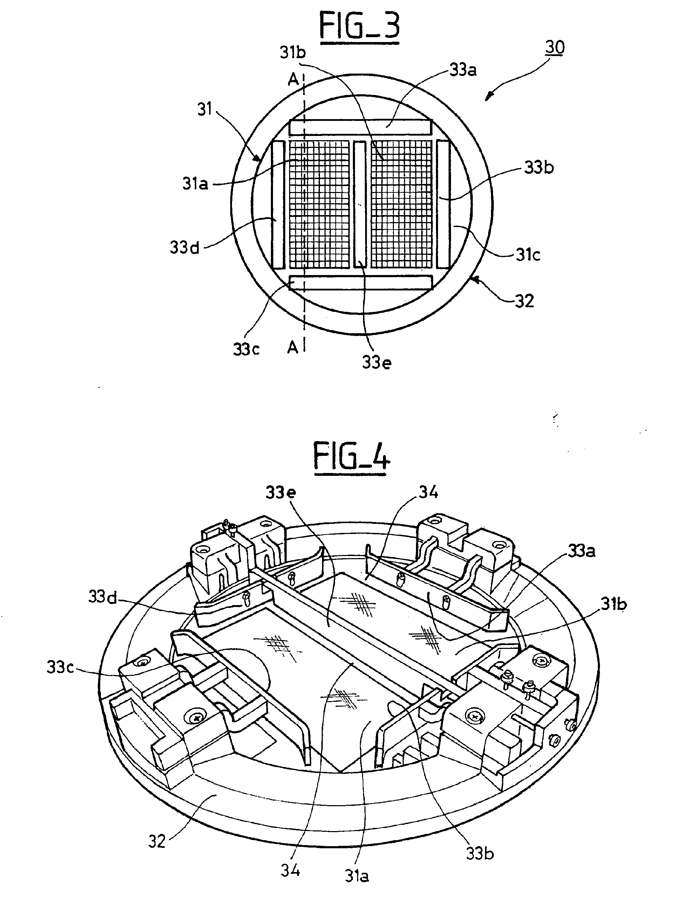

Le dispositif 30 de fabrication de masques par gravure plasma d'un substrat semi-conducteur 31 selon la présente invention est représenté schématiquement sur la figure 3. Les masques une fois réalisés se présentent par exemple sous la forme de deux zones rectangulaires 31 a et 31 b de motifs gravés dans le substrat 31, entourées d'une zone 31 c qui n'a pas été gravée. Les zones 31 a et 31 b ont par exemple une longueur de 132,57mm et une largeur de 54,43mm, et portent un motif en réseau.

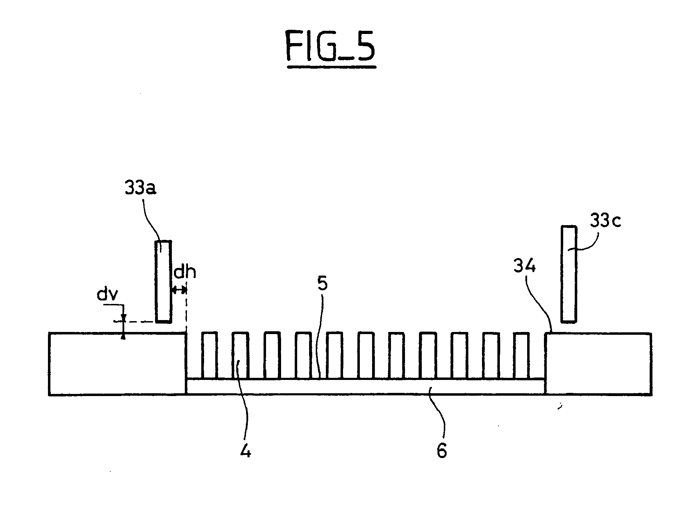

Le dispositif 30 représenté sur les figures 3 à 5 comporte un système de maintien 32 du substrats 31 sur lequel est fixé un moyen de confinement des ions, par exemple cinq plaques 33a, 33b, 33c, 33d, 33e formant écran, encadrant et séparant les zones de motifs 31 a et 31 b disposés côte à côte.

L'écran est en métal, de préférence en aluminium, et formé de plaques 33a-33e qui sont disposées à une distance dh faible et constante, par exemple comprise entre 3mm et 6mm, de la limite 34 entre les zones de motifs 31 a et 31 b et la zone 31 c non gravée. Ces plaques 33a-33e sont par conséquent placés au-dessus de la zone 31 c non gravée, à une distance dv qui peut être comprise entre 3mm et 6mm par exemple.

Les plaques 33a-33e sont fixées sur le système de maintien 32 du substrat 31 de telle sorte qu'un intervalle ouvert sépare chaque plaque du substrat 31.

## Revendications

1. Dispositif de fabrication d'un masque par gravure par plasma d'un substrat semiconducteur, ledit dispositif comprenant
- un substrat semiconducteur (1) dont une partie de la surface est partiellement recouverte d'un masque (3) protégeant au moins une zone qui ne doit pas être gravée (31 c) et laissant apparente au moins une zone comportant un motif à graver (31 a, 31 b),
- un support pour ledit substrat, et
- un moyen de génération d'un plasma sous forme d'un flux d'ions en direction dudit substrat,
- un moyen de confinement desdits ions
**caractérisé en ce que** ledit moyen de confinement desdits ions comporte au moins un écran en matériau conducteur disposé au-dessus dudit substrat (1) et le long de la limite séparant ladite zone de motif à graver (31 a, 31 b) de ladite zone ne devant pas être gravée (31c), ledit écran ayant la forme de plaques verticales (33a, 33b, 33c, 33d, 33e) disposées parallèlement à chacun des côtés de la zone de motif à graver (31a, 31b) en forme de quadrilatère.

2. Dispositif selon la revendication 1, dans lequel ledit écran est disposé à une distance constante de la limite de la zone de motif à graver.

3. Dispositif selon la revendication 2, dans lequel ledit écran est disposé à une distance horizontale constante à l'extérieur de la limite de la zone de motif à graver.

4. Dispositif selon la revendication 2, dans lequel ledit écran est disposé à une distance verticale constante du substrat.

5. Dispositif selon l'une des revendications 2 à 4, dans lequel ladite distance constante est inférieure à 10mm.

6. Dispositif selon l'une des revendications précédentes, dans lequel la hauteur de l'écran est comprise entre 5mm et 20mm.

7. Dispositif selon l'une des revendications précédentes, dans lequel ledit substrat comporte une pluralité de zones comportant des motifs à graver séparées les unes des autres par des zones ne devant pas être gravée.

8. Dispositif selon la revendication 7, dans lequel le écran s'interrompt aux angles du quadrilatère lorsque l'angle est distant d'une autre zone de motif à graver d'une distance inférieure ou égale à ladite distance constante.

9. Dispositif selon l'une des revendications précédentes, dans lequel l'écran s'interrompt aux angles du quadrilatère lorsque l'angle est distant d'une pièce en matériau conducteur d'une distance inférieure ou égale à ladite distance constante.

10. Dispositif selon l'une des revendications précédentes, dans lequel ledit écran est en métal.

11. Dispositif selon la revendication 10, dans lequel ledit écran est en aluminium.

## Claims

1. A device for manufacturing a plasma etch mask of a semiconductor wafer, said device comprising
- a semiconductor wafer (1) of which one part of the surface is covered with a mask (3) protecting at least one area that must not be etched (31c) and leaving exposed at least one area comprising a pattern to be etched (31 a, 31b),
- a mount for said wafer, and
- a means of generating a plasma in the form of an ion flux aimed at said wafer,
- a means of containing said ions,
**characterized in that** said means of containing said ions comprises at least one screen made of a conductive material disposed above said wafer (1) and along the boundary separating said etch pattern area (31a, 31 b) from said area that must not be etched (31 c), said screen having the shape of vertical plates (33a, 33b, 33c, 33d, 33e) disposed parallel to each of the sides of the etch pattern area (31 a, 31b) in the shape of a quadrilateral.

2. A device according to claim 1, wherein said screen is disposed at a constant distance away from the boundary of the etch pattern area.

3. A device according to claim 2, wherein said screen is disposed a constant horizontal distance outside the boundary of the etch pattern area.

4. A device according to claim 2, wherein said screen is disposed at a constant vertical distance from the wafer.

5. A device according to one of the claims 2 to 4, wherein said constant distance is less than 10mm.

6. A device according to one of the preceding claims, wherein the height of the screen is comprised between 5mm and 20mm.

7. A device according to one of the preceding claims, wherein said wafer comprises a plurality of areas comprising patterns to be etched separated from one another from areas that must not be etched.

8. A device according to claim 7, wherein the screen is interrupted at the quadrilateral's angles when the angle's distance away from another etch pattern area is less than or equal to said constant distance.

9. A device according to one of the preceding claims, wherein the screen is interrupted at the quadrilateral's angles when the angle's distance away from a part made of a conductive material is less than or equal to said constant distance.

10. A device according to one of the preceding claims, wherein said screen is made of metal.

11. A device according to claim 10, wherein said screen is made of aluminium.

## Patentansprüche

1. Vorrichtung zur Herstellung einer Maske durch Plasmaätzen eines Halbleitersubstrats, wobei die besagte Vorrichtung umfasst:
- Ein Halbleitersubstrat (1), von dem ein Teil der Oberfläche teilsweise mit einer Maske (3) abgedickt ist, welche mindestens einen Bereich, der nicht geätzt (31c) werden soll, schützt und mindestens einen Bereich, auf welchem ein Muster (31 a, 31b) geätzt werden soll, frei lässt,
- eine Unterlage für das besagte Substrat, und
- ein Mittel zur Erzeugung eines Plasmas in der Form eines Ionenstroms in Richtung des besagten Substrats,
- ein Mittel zum Einschließen der besagten Ione,
**dadurch gekennzeichnet**, das besagte Mittel zum Einschließen der besagten Ione mindestens eine über dem besagten Substrat (1) und längs der Grenze, die den besagten Bereich für das zu ätzende Muster (31 a, 31b) von dem besagten Bereich, der nicht geätzt werden soll (31c), trennt, angeordnete Blende aus Leitermaterial umfasst, wobei die besagte Blende die Form von vertikal angeordneten Platten (33a, 33b, 33c, 33d, 33e), die parallel zu einer jeden Seite des Bereichs für das zu ätzende Muster (31a, 31b) quaderförmig angeordnet sind, aufweist.

2. Vorrichtung nach Anspruch 1, wobei die besagte Blende in einem konstanten Abstand von der Grenze des Bereichs für das zu ätzende Muster angeordnet ist.

3. Vorrichtung nach Anspruch 2, wobei die besagte Blende in einem konstanten horizontalen Abstand außerhalb der Grenze des Bereichs für das zu ätzende Muster angeordnet ist.

4. Vorrichtung nach Anspruch 2, wobei die besagte Blende in einem konstanten vertikalen Abstand zu dem Substrat angeordnet ist.

5. Vorrichtung nach einem der Ansprüche 2 bis 4, wobei der besagte konstante Abstand kleiner als 10 mm ist.

6. Vorrichtung nach einem der vorstehenden Ansprüche, wobei die Höhe der Blende zwischen 5 mm und 20 mm beträgt.

7. Vorrichtung nach einem der vorstehenden Ansprüche, wobei das besagte Substrat eine Mehrzahl von Bereichen für zu ätzende Muster enthält, welche durch Bereiche, die nicht geätzt werden sollen, voneinander getrennt sind.

8. Vorrichtung nach Anspruch 7, wobei die besagte Blende an den Winkeln des Vierecks unterbrochen wird, wenn sich der Winkel von einem anderen Bereich für das zu ätzende Muster in einem Abstand befindet, welcher kleiner als der oder gleich dem besagten konstanten Abstand ist.

9. Vorrichtung nach einem der vorstehenden Ansprüche, wobei die Blende an den Winkeln des Vierecks unterbrochen wird, wenn sich der Winkel von einem Teil aus Leitermaterial in einem Abstand befindet, welcher kleiner als der oder gleich dem besagten konstanten Abstand ist.

10. Vorrichtung nach einem der vorstehenden Ansprüche, wobei die besagte Blende aus besteht.

11. Vorrichtung nach Anspruch 10, wobei die besagte Blende aus Aluminium besteht.
